# EUROPÄISCHE PATENTSCHRIFT

(11) **EP 1 954 115 B1**
(45) Veröffentlichungstag und Bekanntmachung des Hinweises auf die Patenterteilung: **16.07.2014**
(21) Anmeldenummer: 08100520.9
(22) Anmeldetag: 16.01.2008
(51) Int. Cl.: H05K 13/04

(54) **Mehrfach-Bestückkopf mit kollektivem Drehantrieb und verfahrbarem Hubantrieb für Bauelement-Halteeinrichtungen**
Multiple mounting head with collective rotary drive and adjustable lifting device for component holding devices
Tête à implanter multiple dotée d'un entraînement rotatif collectif et d'un entraînement d'élévation mobile pour dispositifs de retenue de composants

(30) Priorität: 01.02.2007 DE 102007005151
(43) Veröffentlichungstag der Anmeldung: 06.08.2008
(73) Patentinhaber: ASM Assembly Systems GmbH & Co. KG, 81379 München (DE)
(72) Erfinder: Rauch, Robert, 82327 Tutzing (DE)
(74) Vertreter: Patentanwälte Bals & Vogel

(56) Entgegenhaltungen:
- EP-A2- 1 161 129
- EP-A2- 1 566 994
- EP-A2- 1 686 845

## Beschreibung

Die Erfindung betrifft einen Bestückkopf, eine Bestückvorrichtung sowie ein Verfahren zum Bestücken von Substraten mit elektronischen Bauelementen.

Bei der automatischen Bestückung von Substraten bzw. Bauelementeträgern mittels so genannter Bestückautomaten werden Bauelemente von einer Bauelement-Zuführeinrichtung an bestimmten Abholpositionen bereitgestellt und dort von einem Bestückkopf abgeholt, welcher mittels eines Positioniersystems innerhalb eines Arbeitsbereiches positioniert werden kann. Die abgeholten Bauelemente werden von dem Bestückkopf zu einer Bestückposition transportiert und auf dem zu bestückenden Substrat an durch entsprechende Anschlussflächen definierte Einbaupositionen aufgesetzt.

Um eine möglichst hohe Bestückleistung zu erreichen, wurden sog. Mehrfach-Bestückköpfe entwickelt. Unter dem Begriff Bestückleistung ist in diesem Zusammenhang die Anzahl an Bauelementen zu verstehen, die innerhalb einer vorgegebenen Zeiteinheit, beispielsweise innerhalb einer Stunde, auf einem zu bestückenden Substrat mit einer geforderten Genauigkeit platziert werden können.

Ein Mehrfach-Bestückkopf ist in der Lage, von der Bauelement-Zuführeinrichtung gleichzeitig mehrere Bauelemente aufzunehmen und diese nach einer eventuellen optischen Vermessung sequentiell an verschiedenen Positionen auf dem Substrat aufzusetzen. Dieses Prinzip wird häufig als Collect & Place Prinzip bezeichnet. Um die vom Bestückkopf aufgenommenen Bauelemente lagerichtig aufsetzen zu können, ist es nicht nur erforderlich, dass die Halteeinrichtungen relativ zu dem Bestückkopf abgesenkt, sondern dass die Haltevorrichtungen auch um ihre Längsachsen gedreht werden können.

Um das Gewicht von Mehrfach-Bestückköpfen möglichst gering zu halten, ist es bekannt, nicht alle Halteeinrichtungen mit einer eigenen Antriebstechnik zum Drehen und zum Heben bzw. Senken zu versehen. Vielmehr können einzelne Antriebskomponenten innerhalb des Bestückkopfes für mehrere Halteeinrichtungen verwendet werden. So kann beispielsweise ein kollektiver Drehantrieb verwendet werden, mit dem alle Halteeinrichtungen gemeinsam um Ihre Längsachse gedreht werden. Dies kann entweder für alle Halteeinrichtungen gleichzeitig oder auch nacheinander erfolgen, wenn die Halteeinrichtungen beispielsweise bei einem sog. Revolverbestückkopf nacheinander an eine bestimmte Position innerhalb des Bestückkopfes gedreht werden.

Die Verwendung von einer gemeinsam für mehrere Halteeinrichtungen verwendeten Antriebstechnik hat jedoch den Nachteil, dass beim Aufsetzen der aufgenommenen Bauelemente auf das zu bestückende Substrat zumindest dann eine bestimmte Bestückreihenfolge eingehalten werden muss, wenn die Bestückleistung nicht erheblich reduziert werden soll. Eine derartige Reduzierung der Bestückleistung würde beispielsweise bei einem Revolverbestückkopf durch ein mehrmaliges Herumdrehen der sternförmig am Rotor des Bestückkopfs angebrachten Halteeinrichtungen verursacht werden. Dies hat zur Folge, dass insbesondere dann, wenn mehrere verschiedenartige Bauelemente auf das Substrat aufgesetzt werden sollen, der Bestückkopf eventuell zusätzliche Verfahrwege zurücklegen muss, um entsprechend einer vorgegebenen Bestücksequenz die Bauelemente jeweils an der korrekten Position aufzusetzen.

Aus der Patentschrift US 7 159 395 B2 ist ein Bestückkopf bekannt, bei dem die Absenkbewegung der einzelnen Halteeinrichtungen durch einen um die Rotorachse verdrehbaren Hubaktuator erfolgt. Die einzelnen Halteeinrichtungen sind im Rotor drehfest gelagert. Die zu bestückenden Bauelemente werden durch eine Drehung Rotors in die jeweilige Sollwinkellage gedreht, wobei der Hubaktuator ebenfalls durch eine Drehung um die Rotordrehachse in diese Position nachgeführt wird. Die x-y-Koordinaten werden über eine Verfahrbewegung des Portals korrigiert.

Weiterhin ist aus der Patentschrift US 6 588 096 B1 ein Bestückkopf mit mehreren auf einer Kreislinie angeordneten, zueinander parallelen Halteeinrichtungen bekannt, wobei die Halteeinrichtungen in einem drehfest angeordneten Träger einzeln drehbar und längsverschiebbar gelagert sind. Vor dem Aufsetzen der Bauelemente auf eine Leiterplatte wird die betreffende Halteeinrichtung durch einen zentralen Drehantrieb 43, 45, 46, 42 in die jeweilige Sollwinkellage verdreht. Oberhalb der Halteeinrichtungen sind diesen einzeln Pneumatikzylinder 34 zugeordnet, durch die eine der Halteeinrichtungen auf Anschlag vorgeschoben werden kann. Diese vorselektierte Halteeinrichtung wird anschließend durch einen geregelten Hubantrieb 40, 39, 38 auf das Abhol- bzw. Aufsetzniveau abgesenkt.

Aus der EP 1 566 994 offenbart einen Bestückkopf zum Bestücken von Substraten mit elektronischen Bauelementen. Der Bestückkopf weist einen Stator und einen Rotor, welcher relativ zu dem Stator um eine Rotordrehachse drehbar ist, auf. Ferner sind bei dem Bestückkopf Halteeinrichtungen zum Aufnehmen der elektronischen Bauelemente vorgesehen, die zu einer der Rotordrehachse parallelen Verschieberichtung verschiebbar gelagert sind. Des Weiteren ist aus der EP 1 566 994 ein Hubaktuator bekannt, welcher einer Halteeinrichtung durch Drehung individuell zustellbar ist und der mit der einen Halteeinrichtung individuell koppelbar ist und eine Hubbewegung der einen Halteeinrichtung in der Verschieberichtung bewirken kann.

Der Erfindung liegt die Aufgabe zugrunde, einen Bestückkopf zu schaffen, der in Bezug auf mögliche Aufsetzsequenzen insbesondere von unterschiedlichen Bauelementen eine hohe Flexibilität ermöglicht.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Bestückkopf zum Bestücken von Substraten mit elektronischen Bauelementen beschrieben. Der Bestückkopf weist auf (a) einen Stator, (b) einen Rotor, welcher relativ zu dem Stator um eine Rotordrehachse drehbar ist und (c) zumindest zwei Halteeinrichtungen zum temporären Aufnehmen der elektronischen Bauelemente, welche Halteeinrichtungen am Rotor in einer zu der Rotordrehachse senkrecht orientierten Ebene angeordnet sind, wobei die Halteeinrichtungen relativ zu dem Rotor um jeweils eine zur Rotordrehachse parallele Drehachse drehbar gelagert und in einer zu der Drehachse parallelen Verschieberichtung verschiebbar gelagert sind. Der Bestückkopf weist ferner auf (d) einen Drehaktuator, welcher mit den Halteeinrichtungen derart gekoppelt ist, dass die Halteeinrichtungen bei einer Aktivierung des Drehaktuators, unabhängig von dem aktuellen Drehwinkel des Rotors, jeweils um ihre Drehachsen gedreht werden, und (e) einen Hubaktuator, welcher relativ zu dem Rotor und zu dem Stator um die Rotordrehachse drehbar gelagert ist, einer Halteeinrichtung der zumindest zwei Halteeinrichtungen durch Drehung individuell zustellbar ist und welcher derart ausgebildet ist, dass er mit der einen Halteeinrichtung individuell koppelbar ist und eine Hubbewegung der einen Halteeinrichtung in der Verschieberichtung bewirken kann.

Der vorliegenden Erfindung liegt die Erkenntnis zugrunde, dass ausgehend von einem horizontal drehenden sog. Revolver-bestückkopf mit lediglich einem kollektiven Drehaktuator für sämtliche Halteeinrichtungen zusätzlich ein um die Rotordrehachse drehbarer Hubaktuator verwendet werden kann. Dieser kann bei einer entsprechenden relativen Winkellage zu dem Rotor selektiv eine Haltevorrichtung von den verschiedenen Haltevorrichtungen entlang einer z-Richtung bewegen. Die z-Richtung verläuft dabei parallel zu der Rotordrehachse bzw. parallel zu den einzelnen Drehachsen der Halteeinrichtungen.

Die individuelle Zustellbarkeit des Hubaktuators zu den einzelnen Halteeinrichtungen hat den Vorteil, dass Bauelemente durch die einzelnen Halteeinrichtungen in einer beliebigen Sequenz aufgenommen und nach einer eventuell vorgenommenen Bauelement-Vermessung mittels eines Vision Systems in beliebiger Sequenz auf einem Substrat bzw. auf einem Bauelementeträger aufgesetzt werden können. Die Möglichkeit die aufgenommenen Bauelemente in einer von der Abholsequenz unabhängigen Bestücksequenz auf das Substrat aufsetzen zu können hat den Vorteil, dass die für eine vollständige oder zumindest für eine teilweise Bestückung eines Substrates erforderlichen Verfahrwege des Bestückkopfes relativ zu dem Substrat erheblich reduziert werden können. Dadurch kann die Leistung eines Bestückautomaten deutlich erhöht werden.

Bevorzugt kann die Winkellage der am Abhol- bzw. am Aufsetzvorgang beteiligten Halteeinrichtung unabhängig von dem aktuellen Drehwinkel des Rotors frei eingestellt werden. So kann beispielsweise der kollektive Drehaktuator derart angesteuert werden, dass die resultierende Eigenrotationsbewegung der Halteeinrichtungen gerade die Bahndrehung durch die Drehung des Rotors kompensiert. In diesem Fall ändert sich bei einer Rotordrehung die Winkellage des oder der aufgenommenen Bauelemente nicht.

Durch die Verwendung des beschriebenen drehbaren und individuell zustellbaren Hubaktuators kann somit bei einem vertretbaren mechanischen und/oder elektrischen Aufwand die Flexibilität des Bestückkopfes erheblich erhöht werden. Die Erhöhung der Flexibilität des Bestückkopfes im Vergleich zu bekannten Bestückköpfen ist insbesondere dann besonders stark, wenn ein entsprechender Drehantrieb für den individuellen Hubaktuator vollständig unabhängig sowohl von dem kollektiven Drehaktuator als auch von dem individuellen Hubaktuator aktiviert werden kann. Auf diese Weise wird eine flexible und individuelle Zuordnung zwischen dem Hubaktuator und den einzelnen Halteeinrichtungen erreicht.

Gemäß einem Ausführungsbeispiel der Erfindung nach Anspruch 2 weist der Bestückkopf zusätzlich einen weiteren Hubaktuator auf, welcher derart ausgebildet ist, dass er mit einer weiteren Halteeinrichtung koppelbar ist und eine Hubbewegung der weiteren Halteeinrichtung in der Verschieberichtung bewirken kann. Dies hat den Vorteil, dass gleichzeitig zwei der zumindest zwei Halteeinrichtungen entlang der zu der Drehachse parallelen Verschieberichtung verschoben werden können. Damit können beispielsweise bei einer entsprechenden Beabstandung von nebeneinander angeordneten Bauelement-Abholpositionen gleichzeitig zwei Bauelemente von einer Bauelement-Zuführeinrichtung abgeholt werden. Somit wird bei Anwendung des sog. Collect & Place Prinzips der Bauelement-Abholvorgang erheblich beschleunigt. Bei dem Collect & Place Prinzip werden von einem Bestückkopf zunächst mehrere Bauelemente von einer Bauelement-Zuführeinrichtung, welche mehrere einzelne Zuführvorrichtungen aufweist, abgeholt und nach einem Transport zu dem zu bestückenden Substrat nacheinander an entsprechenden Bauelement-Einbaupositionen auf dem Substrat aufgesetzt.

Gemäß einem weiteren Ausführungsbeispiel der Erfindung nach Anspruch 3 ist der weitere Hubaktuator relativ zu dem Stator in einer festen Winkellage in Bezug auf den Stator und/oder in Bezug auf den Rotor angeordnet. Diese Ausführungsform mit einem beweglichen Hubaktuator und einem stationären weiteren Hubaktuator hat den Vorteil, dass der mechanische und der elektrische Aufwand zur Realisierung eines entsprechenden Bestückkopfs im Vergleich zu einem Bestückkopf mit lediglich einem beweglichen Hubaktuator nur unwesentlich höher ist.

Gemäß einem weiteren Ausführungsbeispiel der Erfindung nach Anspruch 4 ist der weitere Hubaktuator relativ zu dem Rotor und zu dem Stator um die Rotordrehachse drehbar gelagert und durch Drehung relativ zu dem Stator einer weiteren Halteeinrichtung der zumindest zwei Halteeinrichtungen individuell zustellbar. Dabei ist der weitere Hubaktuator derart ausgebildet, dass er mit der einen weiteren Halteeinrichtung individuell koppelbar ist und eine Hubbewegung der einen weiteren Halteeinrichtung in der Verschieberichtung bewirken kann.

Diese Ausführungsform mit zwei beweglichen Hubaktuatoren hat den Vorteil, dass die Flexibilität bezüglich der AufnahmeSequenz von mehreren elektronischen Bauelementen und der Aufsetz-Sequenz von mehreren elektronischen Bauelementen weiter erhöht wird. Durch eine entsprechende Positionierung der beiden beweglichen Hubaktuatoren können somit zwei beliebige der zumindest zwei Halteeinrichtungen parallel zu deren Drehachsen individuell, d.h. auch gleichzeitig, verschoben werden. Somit können im Fall von mehr als zwei Halteeinrichtungen unabhängig von der Winkellage des Rotors zwei Haltevorrichtungen des Bestückkopfes bzgl. einer Hubbewegung aktiviert werden, welche Haltevorrichtungen zueinander einen Abstand aufweisen, der gerade dem Abstand zwischen zwei unmittelbar oder mittelbar nebeneinander angeordneten Bauelement-Abholpositionen entspricht.

Anders ausgedrückt bedeutet dies, dass die Bereitstellung von zwei variabel und unabhängig voneinander drehbaren Hubaktuatoren den Vorteil aufweist, dass während der Drehung des Rotors gleichzeitig zwei beliebige Halteeinrichtungen entlang einer zu der Rotordrehachse parallelen z-Richtung verschoben bzw. gehoben und gesenkt werden können. Auch dies kann zu einer Optimierung von Abhol- und/oder Aufsetzsequenzen bei einem Bestückvorgang beitragen. Auf jeden Fall ist mit dem beschriebenen Bestückkopf mit zwei beweglichen Hubaktuatoren eine weitere Parallelisierung der Bauelement-Aufnahme und ggf. des Bauelement-Aufsetzens möglich. Im Falle von mehr als zwei Halteeinrichtungen ist somit nicht für jede Halteeinrichtung ein eigener Hubaktuator erforderlich, trotzdem ist infolge der freien Winkel-Positionierbarkeit der beiden Hubaktuatoren eine quasi individuelle Verschiebung von Halteeinrichtungen möglich.

Gemäß einem weiteren Ausführungsbeispiel der Erfindung nach Anspruch 5 weisen der Hubaktuator und/oder der weitere Hubaktuator ein Koppelelement auf, welches mit einem Mitnehmerelement in Eingriff bringbar ist. Dabei ist das Mitnehmerelement einer der zumindest zwei Halteeinrichtungen zugeordnet.

Die Verwendung von einem Mitnehmerelement hat den Vorteil, dass die mechanische Kopplung zwischen dem Hubaktuator und/oder dem weiteren Hubaktuator zum Zwecke einer Verschiebung der jeweiligen Halteeinrichtung auf einfache Weise realisiert werden kann. Es wird jedoch darauf hingewiesen, dass auch andere Ankopplungen wie beispielsweise eine magnetische Ankopplung zwischen Halteeinrichtung und dem Hubaktuator und/oder dem weiteren Hubaktuator möglich ist. Eine magnetischen Ankopplung kann durch eine entsprechende Bestromung eines Elektromagneten erfolgen, welcher in bekannter Weise mit einem magnetischen Element auf der Gegenseite wechselwirkt.

Gemäß einem weiteren Ausführungsbeispiel der Erfindung nach Anspruch 6 weist der Bestückkopf zusätzlich zumindest zwei Federelemente auf, welche derart angeordnet sind, dass sie jeweils eine Halteeinrichtung der zumindest zwei Halteeinrichtungen in eine Ausgangsposition drücken. Bei einer Aktivierung des Hubaktuators oder des weiteren Hubaktuators ist die Halteeinrichtung entlang der zu der Drehachse parallelen Verschieberichtung auslenkbar.

Die Verwendung von federbelasteten bzw. federvorgespannten Halteeinrichtungen hat den Vorteil, dass sich die Halteeinrichtungen ohne entsprechende Aktivierung durch einen Hubaktuator in einer genau definierten Ausgangslage befinden. Zudem kann die Verschiebung der Halteeinrichtung durch eine einfache Druckbewegung beispielsweise mittels eines Stößels erfolgen. Außerdem erfolgt nach einer Auslenkung automatisch ein präzises Rückstellen der Halteeinrichtung in die Ausgangslage.

Gemäß einem weiteren Ausführungsbeispiel der Erfindung nach Anspruch 7 sind der Drehaktuator, der Hubaktuator, ein Drehantrieb für den Hubaktuator und/oder ein Drehantrieb für den Rotor außerhalb der Rotordrehachse angeordnet. Da die beschriebenen Aktuatoren bzw. Antriebe jeweils eine nicht zu vermeidende Wärmequelle darstellen, hat die beschriebene räumliche Anordnung der Aktuatoren bzw. Antriebe in Bezug auf die Rotordrehachse den Vorteil, dass der Wärmeeintrag dieser Wärmequellen auf die Rotordrehachse auf einfache Weise reduziert ist. Damit kann die Temperatur des am stärksten für die Abhol- und insbesondere für die Bestückgenauigkeit relevanten Elements auch bei unterschiedlichen Betriebsbedingungen weitgehend konstant gehalten werden.

Gemäß einem weiteren Ausführungsbeispiel der Erfindung nach Anspruch 8 weist der Bestückkopf zusätzlich zumindest zwei weitere Halteeinrichtungen zum temporären Aufnehmen der elektronischen Bauelemente auf. Die weiteren Halteeinrichtungen sind ebenfalls am Rotor in einer zu der Rotordrehachse senkrecht orientierten Ebene angeordnet. Die weiteren Halteeinrichtungen sind ferner relativ zu dem Rotor um eine zur Rotordrehachse parallele Drehachse drehbar und in einer zu der Drehachse parallelen Verschieberichtung verschiebbar gelagert. Dabei ist der Drehaktuator auch mit den weiteren Halteeinrichtungen derart gekoppelt, so dass die weiteren Halteeinrichtungen bei einer Aktivierung des Drehaktuators jeweils um ihre Drehachsen gedreht werden. Der Hubaktuator ist einer weiteren Halteeinrichtung der zumindest zwei weiteren Halteeinrichtungen individuell zustellbar. Ferner ist der Hubaktuator mit der einen weiteren Halteeinrichtung individuell koppelbar, so dass er eine Hubbewegung der einen weiteren Halteeinrichtung in der Verschieberichtung bewirken kann.

Die Verwendung von zumindest vier Haltevorrichtungen hat den Vorteil, dass die bereits für lediglich zwei Halteeinrichtungen erforderliche Antriebstechnik ohne einen signifikant größeren Aufwand auch für mehrere Halteeinrichtungen genutzt werden kann. Die Komplexität des beschriebenen Bestückkopfes erhöht sich demzufolge auch bei Verwendung von mehreren Halteeinrichtungen bzw. von mehreren weiteren Halteeinrichtung nur unwesentlich. Im Gegensatz dazu erhöht sich bei der Verwendung von mehreren Halteeinrichtungen bzw. weiteren Halteeinrichtungen die Leistung des Bestückkopfes erheblich.

Mit dem nebengeordneten Anspruch 9 wird eine Bestückvorrichtung zum Bestücken von Substraten mit elektronischen Bauelementen beschrieben. Die Bestückvorrichtung weist einen Bestückkopf nach einem der oben beschriebenen Ansprüche auf.

Der Bestückvorrichtung liegt die Erkenntnis zugrunde, dass der oben beschriebene Bestückkopf auf vorteilhafte Weise anstelle eines herkömmlichen Bestückkopfes in einem Bestückautomaten verwendet werden kann. Dabei können aufgrund des um die Rotordrehachse drehbaren Hubaktuators des Bestückkopfes selektiv einzelne Halteeinrichtungen angehoben bzw. abgesenkt werden. Auf diese Weise wird die Flexibilität der gesamten Bestückvorrichtung erheblich erhöht, da im Falle des gleichzeitigen Transports von mehreren Bauelementen von einer Bauelement-Zuführvorrichtung hin zu einem Bestückbereich der Bestückvorrichtung (sog. Collect & Place Prinzip) die Aufsetzsequenz weitgehend unabhängig von der Aufnahmesequenz der Bauelemente gewählt werden kann.

Mit dem unabhängigen Anspruch 10 wird ein Verfahren zum Bestücken von Substraten mit elektronischen Bauelementen beschrieben. Das Verfahren weist auf: (a) Aufnehmen von zumindest zwei Bauelementen von einer Bauelement-Zuführeinrichtung mittels eines Bestückkopfes nach einem der oben beschriebenen Ansprüche, (b) Positionieren des Bestückkopfes relativ zu einem zu bestückenden Substrat, und (c) Aufsetzen der Bauelemente auf das Substrat an vorgegebenen durch Bauelement-Anschlussflächen definierten Aufsetzpositionen.

Der Bestückkopf kann dabei mittels eines Flächepositioniersystems relativ zu einem feststehenden Chassis eines Bestückautomaten zwischen der Bauelement-Zuführeinrichtung und einem Bestückfeld frei positioniert werden, in welchem sich das zu bestückende Substrat befindet. Der Bestückkopf kann alternativ auch um eine relativ zum Chassis des Bestückautomaten stationäre Rotordrehachse drehbar sein, so dass der Bauelementtransport zwischen Bauelement-Zuführeinrichtung und zu bestückendem Substrat durch die Rotation des Bestückkopfes erfolgt. Um Bauelemente von verschiedenen Abholpositionen der Bauelement-Zuführeinrichtung aufnehmen zu können kann bei einer stationären Rotordrehachse die Bauelement-Zuführeinrichtung mittels einer geeigneten Verschiebevorrichtung relativ zu der Rotordrehachse bewegt werden. In analoger Weise kann das zu bestückende Substrat bevorzugt in einer Ebene senkrecht zu der Rotordrehachse verschoben werden, so dass ein Aufsetzen der Bauelemente an verschiednen Positionen auf dem zu bestückenden Substrat möglich ist.

Das Aufnehmen der Bauelemente kann sequentiell oder auch gleichzeitig erfolgen. Im Falle einer gleichzeitigen Bauelement-Aufnahme ist selbstverständlich eine geeignete Beabstandung zwischen verschiedenen Bauelement-Aufnahmepositionen in Bezug auf die Beabstandung zwischen einzelnen Halteeinrichtungen des Bestückkopfes erforderlich. Gleiches gilt auch für das Aufsetzen der Bauelemente, welches Aufsetzen ebenfalls nacheinander oder gleichzeitig erfolgen kann. Bei einem gleichzeitigen Aufsetzen muss die Bedingung erfüllt sein, dass die Beabstandung der entsprechenden Bauelement-Aufsetzpositionen einem relativen Abstand zwischen zumindest zwei Halteeinrichtungen des Bestückkopfes entspricht.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.
- Figur 1: zeigt eine perspektivische Darstellung einer Bestückvorrichtung mit einem schematisch dargestellten Bestückkopf, welcher Bestückkopf einen kollektiven Drehabtrieb und einen selektiv zustellbaren Hubantrieb für zwei Bauelement-Halteeinrichtungen aufweist.
- Figur 2: zeigt eine perspektivische schematische Darstellung eines Zweifach-Bestückkopfes mit einem kollektiven Drehabtrieb und einem selektiv zustellbaren Hubantrieb.
- Figur 3: zeigt eine Konstruktionszeichnung für einen Mehrfach-Bestückkopf mit einem kollektiven Drehabtrieb und einem selektiv zustellbaren Hubantrieb.

An dieser Stelle bleibt anzumerken, dass sich in der Zeichnung die Bezugszeichen von gleichen oder von einander entsprechenden Komponenten lediglich in ihrer ersten Ziffer unterscheiden.

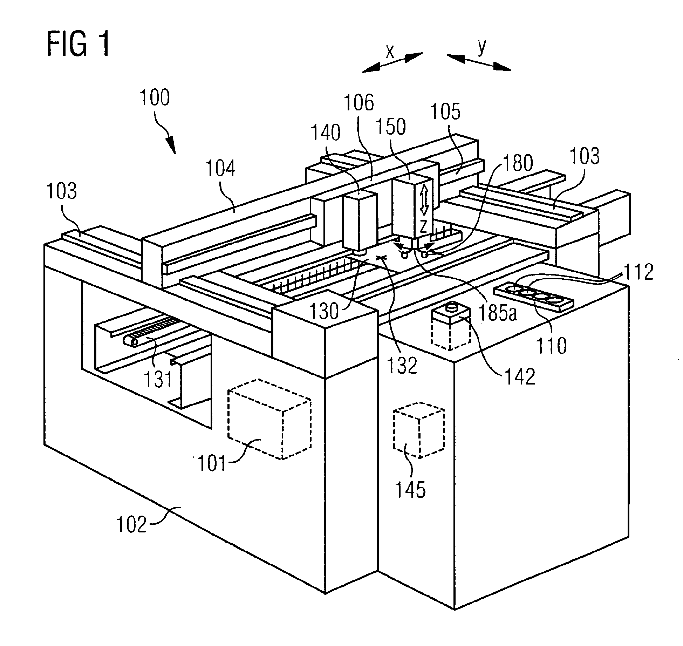

Figur 1 zeigt eine Bestückvorrichtung 100, welcher einen Rahmen 102 aufweist, an der zwei parallel ausgerichtete Führungen 103 angebracht sind. Die beiden Führungen 103 tragen einen quer stehenden Trägerarm 104. Der quer stehende Trägerarm 104 weist selbst eine Führung 105 auf, an welchem ein Trägerelement 106 verschiebbar gelagert ist. Die beiden Führungen 103 verlaufen entlang einer y-Richtung, die Führung 105 verläuft entlang einer x-Richtung. An dem Trägerelement 106 ist ein Bestückkopf 150 angeordnet, welcher zwei Halteeinrichtungen 180 aufweist.

Die beiden Halteeinrichtungen 180 sind an einem nicht dargestellten Rotor des Mehrfach-Bestückkopfes 150 befestigt, welcher Rotor um eine Rotordrehachse drehbar ist. Die Rotordrehachse ist parallel zu einer zu der x-Richtung und zu der y-Richtung senkrechten z-Richtung orientiert. Die entsprechende Drehbewegung der Halteeinrichtungen 180 bzw. des Rotors ist durch den Doppelpfeil verdeutlicht, der mit dem Bezugszeichen 185a versehen ist.

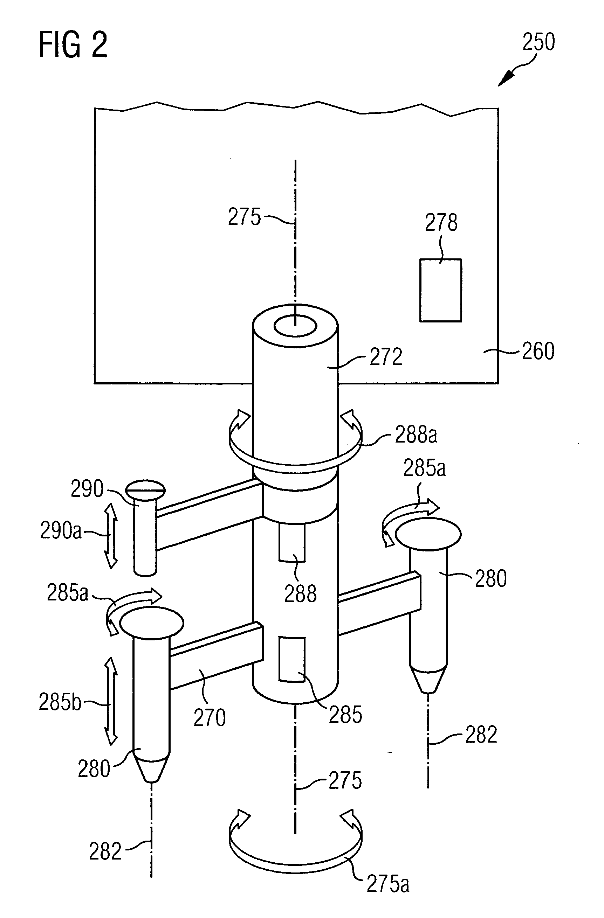

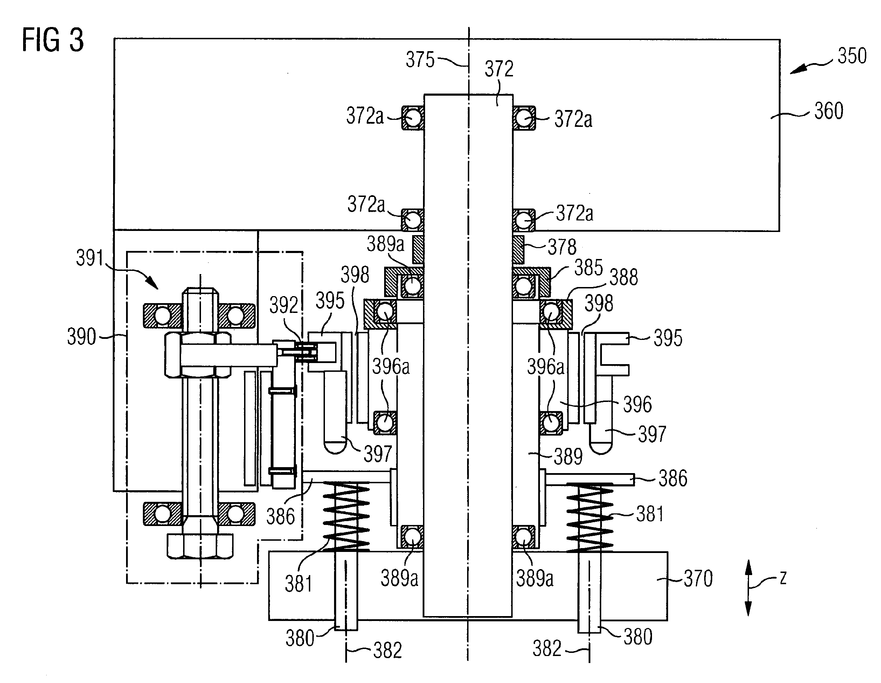

Die Halteeinrichtungen sind sog. Saugpipetten 180, die mittels eines in Figur 1 nicht dargestellten Hubaktuators entlang der z-Richtung verschiebbar sind. Wie nachfolgend anhand von Figur 2 und Figur 3 erläutert, ist dieser Hubaktuator ebenfalls um die Rotordrehachse drehbar gelagert. Damit kann der Hubaktuator trotz einer Drehung der beiden Halteeinrichtungen 180 jeweils mit einer der beiden Halteeinrichtungen 180 unabhängig von deren Winkellage zum Zwecke einer Hub- bzw. Senkbewegung individuell gekoppelt werden.

Um die Winkellage von aufgenommenen Bauelementen zu korrigieren und um damit die Bauelemente in einer korrekten Orientierung bestücken zu können, ist ferner ein nicht dargestellter Drehaktuator vorgesehen. Mittels des Drehaktuators können beide Saugpipetten 180 in synchroner Weise um ihre jeweilige Längsachse gedreht werden.

Es wird an dieser Stelle ausdrücklich darauf hingewiesen, dass die hier und nachfolgend beschriebene Kombination von einem kollektiven Drehaktuator und einem individuell bereitstellbaren Hubaktuator nicht auf einen Bestückkopf mit lediglich zwei Bauelement-Halteeinrichtungen 180 beschränkt ist.

Im Prinzip kann der Mehrfach-Bestückkopf beliebig viele Halteeinrichtungen aufweisen, so dass eine entsprechend hohe Anzahl an Bauelementen gleichzeitig transportiert werden kann.

Die Bestückvorrichtung 100 weist ferner eine Bauelement-Zuführeinrichtung auf, die zumindest zwei Zuführvorrichtungen 110 umfasst, welche an mehreren Abholpositionen 112 der Bestückvorrichtung 100 nicht dargestellte elektronische Bauelemente für den Bestückprozess sequentiell bereitstellen. Dabei können an unterschiedlichen Zuführspuren 110 gleichartige oder auch Bauelemente von unterschiedlichem Typ zugeführt werden.

Ferner umfasst die dargestellte Bestückvorrichtung 100 ein Förderband 131, mit dem ein Bauelementeträger bzw. ein Substrat 130 in den Bestückbereich eingebracht werden kann. Die Halteeinrichtungen 180 können durch eine entsprechende translatorische und rotatorische Bewegung des Bestückkopfes 150 parallel zu der x-y-Ebene innerhalb des gesamten Bestückbereichs positioniert werden.

Die Bestückvorrichtung 100 weist außerdem einen Prozessor bzw. eine Datenverarbeitungseinrichtung 101 auf. Auf der Datenverarbeitungseinrichtung 101 kann ein Bearbeitungsprogramm für die Bestückvorrichtung 100 zum Bestücken von Substraten bzw. Leiterplatten mit Bauelementen ausgeführt werden, so dass alle Komponenten der Bestückvorrichtung 100 in synchronisierter Weise arbeiten und somit zu einem fehlerfreien und zügigem Bestücken von Substraten mit Bauelementen beitragen.

An dem Trägerelement 106 ist zusätzlich eine sog. Leiterplatten-Kamera 140 befestigt, welche zur Erfassung einer an dem Bauelementeträger 130 angebrachten Markierung 132 vorgesehen ist. Auf diese Weise kann die genaue Position des in den Bestückbereich eingebrachten Bauelementeträgers 130 durch eine Lagevermessung der Markierung 132 innerhalb des Gesichtsfeldes der Leiterplatten-Kamera 140 bestimmt werden.

Zur Positionsvermessung und zur Kontrolle von durch den Mehrfach-Bestückkopf 150 aufgenommenen Bauelementen ist eine Kamera 142 vorgesehen, welche gemäß dem hier dargestellten Ausführungsbeispiel in einer festen Position an der Bestückvorrichtung 100 angeordnet ist. Die optische Bauelement-Vermessung erfolgt bevorzugt unmittelbar nach der Aufnahme des Bauelementes bzw. der Bauelemente von der Bauelement-Zuführeinrichtung. Dafür wird der Bestückkopf 150 bzw. die jeweilige Bauelement-Halteeinrichtung 180 in das Gesichtsfeld der Bauelemente-Kamera 142 positioniert. Das von der Kamera 142 aufgenommene Bild wird in einer Auswerteeinheit 145 ausgewertet und dabei die Lage des aufgenommenen Bauelements relativ zu der jeweiligen Saugpipette 180 ermittelt.

Die Auswerteeinheit 145 kann auch in der Datenverarbeitungseinrichtung 101 integriert sein. Dabei kann die Auswerteeinheit 145 mittels einer eigenen Hardware oder auch mittels einer geeigneten Software realisiert sein.

Es wird darauf hingewiesen, dass die Erfindung keineswegs auf die Verwendung in der hier dargestellten Bestückvorrichtung 100 beschränkt ist. Die Erfindung kann beispielsweise auch mit einer Bauelemente-Kamera realisiert werden, welche zusammen mit dem Bestückkopf verfahren wird und welche dafür vorgesehen ist, die aufgenommenen Bauelemente während des Transports von der Aufnahmeposition hin zu der Bestückposition zu vermessen.

Figur 2 zeigt eine perspektivische schematische Darstellung eines Zweifach-Bestückkopfes 250, welcher zwei Bauelement-Halteeinrichtungen 280 aufweist, mit denen gleichzeitig zwei ggf. unterschiedliche Bauelemente aufgenommen und zum Zwecke einer Substratbestückung in einen Bestückbereich einer Bestückvorrichtung transportiert werden können. Der Bestückkopf 250 weist einen Stator 260 und einen Rotor 270 auf. Der Stator ist mit einem Chassis 260 des Bestückkopfes 250 fest verbunden. In der Figur 2 sind Chassis 260 und Stator 260 schematischen als gemeinsames Element dargestellt.

Der Rotor 270 ist über eine Hohlwelle 272 mit dem Stator 260 drehbar verbunden, so dass der Rotor 270 um eine Rotordrehachse 275 drehbar ist. Die entsprechende Drehbewegung, welche durch einen Doppelpfeil 275a angedeutet ist, wird von einem schematisch dargestellten Antrieb 278 erzeugt.

Die Hohlwelle dient der pneumatischen Kopplung der als Saugpipetten ausgebildeten Bauelement-Halteeinrichtungen 280 mit einer nicht dargestellten Vakuum-Erzeugungseinheit. Durch eine entsprechende Beaufschlagung der nicht dargestellten Saugkanäle der Saugpipetten 280 mit Unterdruck kann eine pneumatische Haltekraft auf aufgenommene Bauelemente ausgeübt werden. Beim Absetzen der Bauelemente wird dieser Unterdruck selektiv abgeschaltet. Das Ablösen des Bauelements kann in bekannter Weise durch eine kurzfristige Umschaltung eines Pneumatikventils unterstützt werden. Dabei wird der Saugkanal kurzzeitig mit einem leichten Überdruck beaufschlagt, so dass an der Oberfläche eines aufgenommenen Bauelements kurzzeitig eine leichter Überdruck anliegt, der ein Ablösen des Bauelements von der Saugpipette unterstützt.

An dem Rotor 270 sind außerhalb der Rotordrehachse 275 die beiden Halteeinrichtungen 280 angeordnet, so dass sie sich bei einer Drehung des Rotors 270 ebenfalls um die Rotordrehachse 275 drehen. Die Halteeinrichtungen sind außerdem jeweils um ihre Längsachse 282 drehbar gelagert.

Sämtliche Halteeinrichtungen 280 sind außerdem mit einem gemeinsamen Drehaktuator 285 in nicht näher dargestellter Weise beispielsweise mittel eines Riemens gekoppelt. Bei einer Aktivierung des kollektiven Drehantriebs 285 werden somit alle Haltevorrichtungen in synchroner Weise um ihre jeweilige Drehachse 282 gedreht. Diese Eigenrotation der Haltevorrichtungen ist durch die beiden Doppelpfeile 285a angedeutet.

Der Bestückkopf weist ferner einen ebenfalls um die Rotordrehachse 275 drehbar gelagerten Hubaktuator 290 auf. Die Drehung des Hubaktuators 290, welche durch den Doppelpfeil 288a angedeutet ist, kann vollständig unabhängig sowohl von der Drehung des Rotors 270 als auch unabhängig von der Eigenrotation der Halteeinrichtungen 280 erfolgen. Die relative Winkellage zwischen dem Hubaktuator 290 und dem Rotor 270 bzw. den Haltevorrichtungen 280 wird durch eine entsprechende Aktivierung eines Drehantriebs 288 eingestellt. Damit kann der Hubaktuator 290 selektiv mit einer der zumindest zwei Haltevorrichtungen 280 gekoppelt werden. Bei einer entsprechenden Aktivierung des Hubaktuators 290, welche durch einen Doppelpfeil 290a veranschaulicht ist, kann dann die jeweilige Bauelement-Haltevorrichtung 280 relativ zu dem Chassis 260 angehoben bzw. abgesenkt werden. Die durch den Hubaktuator 290 erzeugte Hubbewegung der Bauelement-Haltevorrichtung 280 ist in Figur 2 durch einen Doppelpfeil 285b veranschaulicht.

Figur 3 zeigt eine Konstruktionszeichnung für einen Mehrfach-Bestückkopf 350 gemäß einem Ausführungsbeispiel der Erfindung, welcher Bestückkopf 350 ebenfalls einen so genannten Revolver-Bestückkopf 350 darstellt. Der Bestückkopf 350 weist einen Stator 360 und einen Rotor 370 auf, die über eine erste Hohlwelle 372 miteinander verbunden sind, so dass der Rotor 370 relativ zu dem Stator 360 um eine Rotordrehachse 375 drehbar gelagert ist. Lagerungen 372a sorgen für eine möglichst reibungsarme Drehlagerung der Hohlwelle 372. Ein schematisch dargestellter Drehantrieb 378 sorgt für die nötigen Antriebskräfte, so dass sich der Rotor 370 relativ zu dem Stator bzw. relativ zu dem Chassis 360 des Bestückkopfes 350 mit einer vorgegebenen bevorzugt schrittweise ausgeführten Drehbewegung dreht.

An dem Rotor 370 sind außerhalb der Drehachse 375 zumindest zwei Bauelement-Halteeinrichtungen 380 angeordnet, die zum temporären Aufnehmen von elektronischen Bauelementen eingerichtet sind. Die Haltevorrichtungen 380 sind entlang einer z-Achse verschiebbar gelagert und werden von jeweils einem Federelement 381 in eine obere Ausgangslage gedrückt.

Die Haltevorrichtungen 380 sind ferner jeweils um ihre Längsachse 382 drehbar gelagert und mittels eines zentralen Drehaktuators kollektiv d.h. gemeinsam antreibbar. Der schematisch dargestellte zentrale Drehaktuator ist mit dem Bezugszeichen 385 versehen. Bei einer Aktivierung des zentralen Drehaktuators 385 werden alle Haltevorrichtungen 380 gemeinsam zu einer Rotation um ihre jeweilige Längsachse 382 veranlasst.

Gemäß dem hier dargestellten Ausführungsbeispiel der Erfindung sind die Haltevorrichtungen 380 über eine zweite Hohlwelle 389 und Koppelelemente 386 mit dem Drehaktuator 386 gekoppelt. Die Koppelelemente 386 können beispielsweise Zahnräder, Reibräder oder Riemen sein. Die zweite Hohlwelle 389 ist auf der ersten Hohlwelle 372 aufgesteckt. Lagerungen 389a ermöglichen eine reibungsarme relative Drehung zwischen der zweiten Hohlwelle 389 und der ersten Hohlwelle 372.

Der Bestückkopf 350 weist ferner einen in Bezug auf den Rotor 370 drehbar gelagerten Hubaktuator 390 auf, der in Figur 3 schematisch mittels eines kombinierten Spindel-Riemenantriebs 391 dargestellt ist. Der Hubaktuator 390 kann durch Aktivierung eines Drehantriebes 388 um die Rotordrehachse 375 gedreht werden. Auf diese Weise kann der Hubaktuator 390 in Bezug auf den Rotor 370 jede beliebige Winkellage einnehmen.

Gemäß dem hier dargestellten Ausführungsbeispiel ist der Hubaktuator 390 an einer dritten Hohlwelle 396 befestigt. Die dritte Hohlwelle 396 ist konzentrisch zu den beiden anderen Hohlwellen 372 und 389 angeordnet und mittels Lagerungen 396a relativ zu der Rotordrehachse 375 zentriert. Die Lagerungen 396a erlauben eine reibungsarme Drehlagerung der dritten Hohlwelle 396 relativ zu der zweiten Hohlwelle 372, auf welcher die dritte Hohlwelle 396 aufgesteckt ist.

Eine Kopplung zwischen Hubaktuator 390 und einer der Bauelement-Halteeinrichtungen 380 wird dadurch erreicht, dass der Hubaktuator 390 zunächst in eine in Bezug auf den Rotor 370 geeignete Winkellage gebracht wird, so dass ein Koppelelement 392 des Hubaktuators 390 in ein Mitnehmerelement 395 eingreift, welches der gewünschten Halteeinrichtung 380 zugeordnet ist. Das Mitnehmerelement 395 ist an einem Stößel 397 angebracht, welcher mittels eines Linearlagers 398 entlang der z-Achse verschiebbar ist. Bei einer Abwärtsbewegung des Hubaktuators 390 drückt somit der Stößel 397 auf das zuvor beschriebene Koppelelement 386, so dass die entsprechende Bauelement-Halteeinrichtung 380 unter Überwindung der Spannkraft des Federelements 381 nach unten gedrückt wird. Bei einer Aufwärtsbewegung des Hubaktuators 390 wird die Halteeinrichtung 380 infolge der Spannkraft des Federelements 381 wieder in ihre Ausgangslage zurück gebracht. Auf diese Weise kann unabhängig von der Winkellage des Rotors 370 jede beliebige Bauelement-Halteeinrichtung in Bezug auf das Chassis des Bestückkopfes individuell entlang der z-Richtung verschoben werden. Damit wird die Flexibilität des Bestückkopfes 350 bezüglich möglicher Sequenzen von Aufnahme- und Absetzvorgängen von unterschiedlichen Bauelementen im Rahmen der automatischen Bestückung von Substraten mit elektronischen Bauelementen im Vergleich zu bekannten Bestückköpfen mit einem stationären Hubaktuator erheblich erhöht.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Zusammenfassend bleibt festzustellen:

Diese Anmeldung beschreibt einen Bestückkopf 250 zum Bestücken von Substraten mit Bauelementen. Der Bestückkopf 250 umfasst (a) einen Stator 260, (b) einen Rotor 270, welcher relativ zu dem Stator 260 um eine Rotordrehachse 275 drehbar ist, und (c) zumindest zwei Bauelement-Halteeinrichtungen 280, welche am Rotor 270 in einer zu der Rotordrehachse 275 senkrecht orientierten Ebene angeordnet sind. Die Halteeinrichtungen 280 sind relativ zu dem Rotor 270 um jeweils eine zur Rotordrehachse 275 parallele Drehachse 282 drehbar und in einer zu der Drehachse 282 parallelen Verschieberichtung 285b verschiebbar gelagert. Der Bestückkopf 250 umfasst ferner (d) einen Drehaktuator 285, welcher mit den Halteeinrichtungen 280 derart gekoppelt ist, dass diese bei einer Aktivierung des Drehaktuators 285 jeweils um ihre Drehachsen 282 gedreht werden, und (e) einen Hubaktuator 290, welcher relativ zu dem Rotor 270 um die Rotordrehachse 275 drehbar gelagert und durch Drehung einer ausgewählten Halteeinrichtung 280 individuell zustellbar ist und welcher derart ausgebildet ist, dass er mit der ausgewählten Halteeinrichtung 280 individuell koppelbar ist und eine Hubbewegung der ausgewählten Halteeinrichtung 280 in der Verschieberichtung 285b bewirken kann.

### Bezugszeichenliste

- 100: Bestückvorrichtung
- 101: Datenverarbeitungseinrichtung / Prozessor
- 102: Rahmen
- 103: Führungen
- 104: querstehender Trägerarm
- 105: Führung
- 106: Trägerelement
- 110: Zuführvorrichtungen
- 112: Abholpositionen
- 130: Bauelementeträger / Substrat
- 131: Förderband
- 132: Markierung
- 140: Leiterplatten-Kamera
- 142: Bauelemente-Kamera
- 145: Auswerteeinheit
- 150: Bestückkopf
- 180: Halteeinrichtung / Saugpipette
- 185a: Drehrichtung Rotor

- 250: Bestückkopf
- 260: Chassis / Stator
- 270: Rotor
- 272: erste Hohlwelle
- 275: Rotordrehachse
- 275a: Drehrichtung Rotor 270
- 278: Antrieb für Rotor 270
- 280: Halteeinrichtungen
- 282: Drehachse / Längsachse
- 285: Drehaktuator / kollektiver Drehantrieb
- 285a: kollektive Drehrichtung der Halteeinrichtungen
- 285b: individuelle Verschieberichtung einer Halteeinrichtung
- 288: Drehantrieb für Hubaktuator
- 288a: Drehrichtung Hubaktuator
- 290: drehbarer Hubaktuator
- 290a: Verschieberichtung Hubaktuator

- 350: Bestückkopf
- 360: Chassis / Stator
- 370: Rotor
- 372: erste Hohlwelle (für Rotor 370)
- 372a: Lagerungen
- 375: Rotordrehachse
- 378: Antrieb für Rotor 370
- 380: Halteeinrichtung
- 381: Federelement
- 382: Drehachse / Längsachse
- 385: Drehaktuator / kollektiver Drehantrieb
- 386: Koppelelemente
- 388: Drehantrieb für Hubaktuator
- 389: zweite Hohlwelle (für kollektiven Drehantrieb)
- 389a: Lagerungen
- 390: drehbarer Hubaktuator
- 391: Antrieb mit Spindel und Riemen
- 392: Koppelelement
- 395: Mitnehmerelement
- 396: dritte Hohlwelle (für Drehung Hubaktuator)
- 396a: Lagerungen
- 397: Stößel
- 398: Linearlager

## Patentansprüche

1. Bestückkopf zum Bestücken von Substraten (130) mit elektronischen Bauelementen, der Bestückkopf (150, 250, 350) aufweisend
• einen Stator (260, 360),
• einen Rotor (270, 370), welcher relativ zu dem Stator (260, 360) um eine Rotordrehachse (275, 375) drehbar ist,
• zumindest zwei Halteeinrichtungen (280, 380) zum temporären Aufnehmen der elektronischen Bauelemente, welche Halteeinrichtungen (280, 380) am Rotor (270, 370) in einer zu der Rotordrehachse (275, 375) senkrecht orientierten Ebene angeordnet sind, wobei
die Halteeinrichtungen (280, 380) relativ zu dem Rotor (270, 370) um jeweils eine zur Rotordrehachse (275, 375) parallele Drehachse (282, 282) drehbar gelagert und in einer zu der Drehachse (282, 382) parallelen Verschieberichtung (285b) verschiebbar gelagert sind,
• einen Drehaktuator (285, 385), welcher mit den Halteeinrichtungen (280, 380) derart gekoppelt ist, dass die Halteeinrichtungen (280, 380) bei einer Aktivierung des Drehaktuators (285, 385), unabhängig von dem aktuellen Drehwinkel des Rotors (270, 370), jeweils um ihre Drehachsen (282, 382) gedreht werden, und
• einen Hubaktuators (290, 390), welcher
- relativ zu dem Rotor (270, 370) und zu dem Stator (260, 360) um die Rotordrehachse (275, 375) drehbar gelagert ist,
- einer Halteeinrichtung (280, 380) der zumindest zwei Halteeinrichtungen (280, 380) durch Drehung individuell zustellbar ist und
derart ausgebildet ist, dass er mit der einen Halteeinrichtung (280, 380) individuell koppelbar ist und eine Hubbewegung (285b) der einen Halteeinrichtung (280) in der verschieberichtung bewirken kann.

2. Bestückkopf nach Anspruch 1, zusätzlich aufweisend
einen weiteren Hubaktuator, welcher derart ausgebildet ist, dass er mit einer weiteren Halteeinrichtung koppelbar ist und eine Hubbewegung der weiteren Halteeinrichtung in der Verschieberichtung bewirken kann.

3. Bestückkopf nach Anspruch 2, wobei
der weitere Hubaktuator relativ zu dem Stator (260, 360) in einer festen Winkellage in Bezug auf den Stator (260, 360) und/oder in Bezug auf den Rotor (270, 370) angeordnet ist.

4. Bestückkopf nach Anspruch 2, wobei
der weitere Hubaktuator relativ zu dem Rotor (270, 370) und zu dem Stator (260, 360) um die Rotordrehachse (275, 375) drehbar gelagert und durch Drehung relativ zu dem Stator (260, 360) einer weiteren Halteeinrichtung der zumindest zwei Halteeinrichtungen (280, 380) individuell zustellbar ist und wobei
der weitere Hubaktuator derart ausgebildet ist, dass er mit der einen weiteren Halteeinrichtung individuell koppelbar ist und eine Hubbewegung der einen weiteren Halteeinrichtung in der Verschieberichtung bewirken kann.

5. Bestückkopf nach einem der Ansprüche 1 bis 4, wobei
der Hubaktuator und/oder der weitere Hubaktuator ein Koppelelement (393) aufweisen, welches mit einem Mitnehmerelement (395) in Eingriff bringbar ist, wobei das Mitnehmerelement (395) einer der zumindest zwei Halteeinrichtungen (380) zugeordnet ist.

6. Bestückkopf nach einem der Ansprüche 1 bis 5, zusätzlich aufweisend
zumindest zwei Federelemente (381), welche derart angeordnet sind, dass sie jeweils eine Halteeinrichtung (380) der zumindest zwei Halteeinrichtungen (380) in eine Ausgangsposition drücken, wobei die Halteeinrichtung (380) bei einer Aktivierung des Hubaktuators (390) oder des weiteren Hubaktuators entlang der zu der Drehachse (382) parallelen Verschieberichtung auslenkbar ist.

7. Bestückkopf nach einem der Ansprüche 1 bis 6, wobei
der Drehaktuator (285, 385), der Hubaktuator (290, 390), ein Drehantrieb (388) für den Hubaktuator (390) und/oder ein Drehantrieb (378) für den Rotor (370) außerhalb der Rotordrehachse (375) angeordnet sind.

8. Bestückkopf nach einem der Ansprüche 1 bis 7, zusätzlich aufweisend
• zumindest zwei weitere Halteeinrichtungen zum temporären Aufnehmen der elektronischen Bauelemente, welche weiteren Halteeinrichtungen am Rotor (270, 370) in einer zu der Rotordrehachse (275, 375) senkrecht orientierten Ebene angeordnet sind, wobei
die weiteren Halteeinrichtungen relativ zu dem Rotor (270, 370) um eine zur Rotordrehachse (275, 375) parallele Drehachse drehbar gelagert und in einer zu der Drehachse parallelen Verschieberichtung verschiebbar gelagert sind,
wobei der Drehaktuator (285, 385) auch mit den weiteren Halteeinrichtungen derart gekoppelt ist, dass die weiteren Halteeinrichtungen bei einer Aktivierung des Drehaktuators (285, 385) jeweils um ihre Drehachsen gedreht werden, und wobei der Hubaktuator (290, 390) auch einer weiteren Halteeinrichtung der zumindest zwei weiteren Halteeinrichtungen individuell zustellbar ist, mit der einen weiteren Halteeinrichtung individuell koppelbar ist und eine Hubbewegung der einen weiteren Halteeinrichtung in der Verschieberichtung bewirken kann.

9. Bestückvorrichtung zum Bestücken von Substraten (130) mit elektronischen Bauelementen, die Bestückvorrichtung (100) aufweisend
• einen Bestückkopf (150, 250, 350) nach einem der Ansprüche 1 bis 8.

10. Verfahren zum Bestücken von Substraten (130) mit elektronischen Bauelementen, das Verfahren aufweisend
• Aufnehmen von zumindest zwei Bauelementen von einer Bauelement-Zuführeinrichtung (110) mittels eines Bestückkopfes (150, 250, 350) nach einem der Ansprüche 1 bis 8,
• Positionieren des Bestückkopfes (150, 250, 350) relativ zu einem zu bestückenden Substrat (130), und
• Aufsetzen der Bauelemente auf das Substrat (130) an vorgegebenen durch Bauelement-Anschlussflächen definierten Aufsetzpositionen.

## Claims

1. A mounting head for mounting electronic components on substrates (130), said mounting head (150, 250, 350) comprising
• a stator (260, 360),
• a rotor (270, 370), which can be rotated relative to the stator (260, 360) about a rotor rotation axis (275, 375),
• at least two retaining devices (280, 380) for temporarily picking up the electronic components, which retaining devices (280, 380) are arranged on the rotor (270, 370) in a plane oriented perpendicular to the rotor rotation axis (275, 375), wherein
• the retaining devices (280, 380) are pivotably mounted relative to the rotor (270, 370) each about an axis of rotation (282, 282) parallel to the rotor rotation axis (275, 375), and are mounted such that they can be displaced in a displacement direction (285b) parallel to the axis of rotation (282, 382),
• a rotary actuator (285, 385), which is coupled to the retaining devices (280, 380) in such a manner that when the rotary actuator (285, 385) is activated the retaining devices (280, 380), independent of the actual angle of rotation of the rotor (270, 370), are rotated about their rotary axes (282, 382), and
• a lifting actuator (290, 390), which
- is mounted relative to the rotor (270, 370) and to the stator (260, 360) such that it can pivot about the rotor rotation axis (275, 375),
- one retaining device (280, 380) of the at least two retaining devices (280, 380) is individually adjustable by rotation and
is designed in such a manner that it can be individually coupled to the one retaining device (280, 380) and can effect a lifting movement (285b) of the one retaining device (280) in the displacement direction.

2. The mounting head according to claim 1,
additionally comprising a further lifting actuator, which is designed in such a manner that it can be coupled with a further retaining device and can effect a lifting movement of the further retaining device in the displacement direction.

3. The mounting head according to claim 2, wherein
the further lifting actuator is arranged relative to the stator (260, 360) in a fixed angular position in relation to the stator (260, 360) and/or in relation to the rotor (270, 370).

4. The mounting head according to claim 2, wherein
the further lifting actuator is mounted such that it can pivot relative to the rotor (270, 370) and the stator (260, 360) about the rotor rotation axis (275, 375) and is individually adjustable by rotation relative to the stator (260, 360) of a further retaining device of the at least two retaining devices (280, 380), and wherein
the further lifting actuator is designed in such a manner that it can be individually coupled to the one further retaining device and can effect a lifting movement of the one further retaining device in the displacement direction.

5. The mounting head according to any one of claims 1 to 4, wherein
the lifting actuator and/or the further lifting actuator comprise a coupling element (393), which can be brought into engagement with a driver element (395), the driver element (395) being assigned to one of the at least two retaining devices (380).

6. The mounting head according to any one of claims 1 to 5, additionally comprising
at least two spring elements (381), which are arranged in such a manner that they each push one retaining device (380) of the at least two retaining devices (380) into a starting position, wherein, when the lifting actuator (390) or the further lifting actuator is activated, the retaining device (380) can be deflected along the displacement direction parallel to the axis of rotation (382).

7. The mounting head according to any one of claims 1 to 6, wherein
the rotary actuator (285, 385), the lifting actuator (290, 390), a rotary drive (388) for the lifting actuator (390) and/or a rotary drive (378) for the rotor (370) are arranged outside of the rotor rotation axis (375).

8. The mounting head according to any one of claims 1 to 7, additionally comprising
• at least two further retaining devices for temporarily picking up the electronic components, which retaining devices are arranged on the rotor (270, 370) in a plane oriented perpendicular to the rotor rotation axis (275, 375), wherein
the further retaining devices are pivotably mounted relative to the rotor (270, 370) about an axis of rotation parallel to the rotor rotation axis (275, 375), and are mounted such that they can be displaced in a displacement direction parallel to the axis of rotation,
wherein the rotary actuator (285, 385) is also coupled to the further retaining devices in such a manner that when the rotary actuator (285, 385) is activated, the further retaining devices are each rotated about their respective rotary axes, and wherein also the lifting actuator (290, 390) of a further retaining device of the at least two further retaining devices is individually adjustable, can be individually coupled to a further retaining device and can effect a lifting movement of the one further retaining device in the displacement direction.

9. A mounting device for mounting electronic components on substrates (130), said mounting device (100) comprising
• a mounting head (150, 250, 350) according to any one of claims 1 to 8.

10. A method for mounting electronic components on substrates (130), said method comprising
• picking up of at least two components of a component feeding device (110) using a mounting head (150, 250, 350) according to any one of claims 1 to 8,
• positioning of the mounting head (150, 250, 350) relative to a substrate (130) to be assembled, and
• placement of the components on the substrate (130) at pre-specified placement positions defined by component contact pads.

## Revendications

1. Tête d'équipement pour équiper des substrats (130) avec des composants électroniques, la tête d'équipement (150, 250, 350) comportant
• un stator (260, 360),
• un rotor (270, 370) qui peut tourner autour d'un axe de rotation de rotor (275, 375) par rapport au stator (260, 360),
• au moins deux dispositifs de retenue (280, 380) pour la réception temporaire des composants électroniques, lesquels dispositifs de retenue (280, 380) sont disposés sur le rotor (270, 370) dans un plan orienté perpendiculairement à l'axe de rotation du rotor (275, 375),
les dispositifs de retenue (280, 380) étant montés pivotables respectivement autour d'un axe de rotation (282, 282) parallèle à l'axe de rotation du rotor (275, 375) et étant montés mobiles dans une direction de déplacement (285b) parallèle à l'axe de rotation (282, 382),
• un actionneur rotatif (282, 385) qui est couplé aux dispositifs de retenue (280, 380) de telle sorte que les dispositifs de retenue (280, 380) sont tournés lors d'une activation de l'actionneur rotatif (285, 385), indépendamment de l'angle de rotation actuel du rotor (270, 370), respectivement autour de leurs axes de rotation (282, 382) et
• un actionneur de levage (290, 390) qui
- est monté pivotable autour de l'axe de rotation du rotor (275, 375) par rapport au rotor (270, 370) et au stator (260, 360),
- peut être individuellement approché par rotation d'un dispositif de retenue (280, 380) des au moins deux dispositifs de retenue (280, 380) et
est constitué de telle sorte qu'il peut être couplé individuellement avec le, un dispositif de retenue (280, 380) et peut produire un mouvement de levage (285b) d'un dispositif de retenue (280) dans la direction de déplacement.

2. Tête d'équipement selon la revendication 1 comportant en plus un autre actionneur de levage qui est constitué de telle sorte qu'il peut être couplé avec un autre dispositif de retenue et peut produire un mouvement de levage de l'autre dispositif de retenue dans la direction de déplacement.

3. Tête d'équipement selon la revendication 2 dans laquelle
l'autre actionneur de levage concernant le stator (260, 360) est disposé dans une position angulaire fixe par rapport au stator (260, 360) et/ou par rapport au rotor (270, 370).

4. Tête d'équipement selon la revendication 2 dans laquelle
l'autre actionneur de levage concernant le rotor (270, 370) et le stator (260, 360) est monté pivotable autour de l'axe de rotation du rotor (275, 375) et peut être individuellement approché par rotation concernant le stator (260, 360) d'un autre dispositif de retenue des au moins deux dispositifs de retenue (280, 380)et
dans laquelle
l'autre actionneur de levage est constitué de telle sorte qu'il peut être individuellement couplé avec un autre dispositif de retenue et peut produire un mouvement de levage d'un autre dispositif de retenue dans la direction de déplacement.

5. Tête d'équipement selon une quelconque des revendications 1 à 4 dans laquelle
l'actionneur de levage et/ou l'autre actionneur de levage comporte un élément de couplage (393) qui peut être mis en prise avec un élément d'entraînement (395), l'élément d'entraînement (395) étant attribué à un des au moins deux dispositifs de retenue (380).

6. Tête d'équipement selon une quelconque des revendications 1 à 5 comportant en plus
au moins deux éléments à ressort (381) qui sont disposés de telle sorte qu'ils poussent respectivement un dispositif de retenue (380) des au moins deux dispositifs de retenue (380) dans une position initiale, le dispositif de retenue (380) pouvant être dévié le long de la direction de déplacement parallèle à l'axe de rotation (382) lors d'une activation de l'actionneur de levage (390) ou de l'autre actionneur de levage.

7. Tête d'équipement selon une quelconque des revendications 1 à 6 dans laquelle
l'actionneur de rotation (285, 385), l'actionneur de levage (290, 390), un entraînement de rotation (388) pour l'actionneur de levage (390) et/ou un entraînement de rotation (378) pour le rotor (370) sont disposés en dehors de l'axe de rotation du rotor (375).

8. Tête d'équipement selon une quelconque ds revendications 1 à 7 comportant en plus
• au moins deux autres dispositifs de retenue pour la réception temporaire des composants électroniques, lesquels autres dispositifs de retenue sont disposés sur le rotor (270, 370) dans un plan orienté perpendiculairement à l'axe de rotation du rotor (275, 375), dans laquelle
les autres dispositifs de retenue concernant le rotor (270, 370) sont montés pivotables autour d'un axe de rotation parallèle à l'axe de rotation de rotor (275, 375) et sont montés mobiles dans une direction de déplacement parallèle à l'axe de rotation,
dans laquelle l'actionneur rotatif (285, 385) est également couplé avec les autres dispositifs de retenue de telle sorte que les autres dispositifs de retenue sont tournés respectivement autour de leurs axes de rotation lors d'une activation de l'actionneur rotatif (285, 385) et dans laquelle l'actionneur de levage (290, 390) peut être individuellement approché également d'un autre dispositif de retenue des au moins deux autres dispositifs de retenue, avec lequel un autre dispositif de retenue peut être individuellement couplé et peut produire un mouvement de levage d'un autre dispositif de levage dans la direction de déplacement.

9. Dispositif d'équipement pour équiper des substrats (130) avec des composants électroniques, le dispositif d'équipement (100) comportant
• une tête d'équipement (150, 250, 350) selon une quelconque des revendications 1 à 8.

10. Procédé pour équiper des substrats (130) avec des composants électroniques, le procédé comportant
• la réception d'au moins deux composants d'un dispositif d'alimentation en composants (110) au moyen d'une tête d'équipement (150, 250, 350) selon une quelconque des revendications 1 à 8,
• le positionnement de la tête d'équipement (150, 250, 350) concernant un substrat (130) à équiper et
• la pose des composants sur le substrat (130) à des positions de dépose définies préalablement spécifiées par des surfaces de raccordement de composant.
